# EUROPEAN PATENT SPECIFICATION

(11) **EP 2 402 989 B1**
(45) Date of publication and mention of the grant of the patent: **12.08.2015**
(21) Application number: 11171592.6
(22) Date of filing: 27.06.2011
(51) Int. Cl.: H01L 23/473

(54) **Heat sinks with millichannel cooling**
Kühlkörper mit Millikanalkühlung
Dissipateurs de chaleur avec refroidissement milli-canal

(30) Priority: 29.06.2010 US 826128
(43) Date of publication of application: 04.01.2012
(73) Proprietor: General Electric Company, Schenectady, NY 12345 (US)
(72) Inventor: Pautsch, Adam Gregory, Niskayuna, NY 12309 (US); Gunturi, Satish Sivarama, Niskayuna, NY 12309 (US); Lazatin, Patrick Jose, Niskayuna, NY 12309 (US)
(74) Representative: Illingworth-Law, William Illingworth

(56) References cited:
- DE-A1- 3 411 523
- JP-A- 8 241 943
- US-A- 5 539 617
- US-A1- 2010 038 058
- US-A1- 2010 038 774

## Description

### BACKGROUND

The invention relates generally to power electronics and, more particularly, to advanced cooling for power electronics.

High power converters, such as medium voltage industrial drives, frequency converters for oil and gas, traction drives, Flexible AC Transmission (FACT) devices, and other high power conversion equipment, for example rectifiers and inverters, typically include press-pack power devices with liquid cooling. Non-limiting examples of power devices include integrated gate commutated thyristors (IGCTs), diodes, insulated gate bipolar transistors (IGBTs), thyristors and gate turn-off thyristors (GTOs). Press-pack devices are particularly advantageous in high power applications, and benefits of press-packs include double-sided cooling, as well as the absence of a plasma explosion event during failure.

US 2010/0038774 A1 and US 2010/0038058 A1 disclose heat sinks for cooling an electronic device package.

To construct a high power converter circuit using press-pack devices, heat sinks and press-pack devices are typically sandwiched to form a stack. State-of-the-art power converter stacks typically employ conventional liquid cooled heat sinks with larger diameter cooling channels. In certain applications, thermal grease layers are disposed between respective ones of the press-pack device and the conventional liquid cooled heat sink. In other applications, at least some of the layers are simply held together by pressure, with no thermal grease in between them. This arrangement results in significant contact resistance.

It would be desirable to provide improved heat sink designs which prevent the coolant from leaking onto the electronics during assembly, disassembly, or servicing. It would further be desirable to provide improved heat sink designs that enable the use of heat spreading effects for enhanced cooling of power electronics.

### BRIEF DESCRIPTION

The present invention provides a heat sink as defined in claim 1.

One embodiment of the present invention resides in a heat sink for cooling at least one electronic device package. The electronic device package has an upper contact surface and a lower contact surface. The heat sink includes a lower lid, an upper lid, and a body formed of at least one thermally conductive material. The body is disposed between and sealed to the lower and upper lids and defines at least one inlet manifold configured to receive a coolant and at least one outlet manifold configured to exhaust the coolant. The inlet and outlet manifolds are interleaved and are disposed in a circular or spiral arrangement. A number of millichannels are formed in the body, are disposed in a radial arrangement, and are configured to receive the coolant from the inlet manifolds and to deliver the coolant to the outlet manifolds. The millichannels and inlet and outlet manifolds are further configured to cool one of the upper and lower contact surfaces of the electronic device package.

Another embodiment of the present invention resides in a heat sink for cooling an electronic device package. The heat sink includes a lid and a body formed of at least one thermally conductive material. The body is sealed to the lid and defines at least one inlet manifold configured to receive a coolant and at least one outlet manifold configured to exhaust the coolant. The inlet and outlet manifolds are interleaved and are disposed in a circular or spiral arrangement. A number of millichannels are formed in either the body or the lid, are disposed in a radial arrangement, and are configured to receive the coolant from the inlet manifolds and to deliver the coolant to the outlet manifolds. The millichannels and inlet and outlet manifolds are further configured to cool one of the upper and lower contact surfaces of the electronic device package.

Yet another embodiment of the present invention resides in a heat sink for cooling at least one electronic device package. The heat sink includes a lower lid, an upper lid, and a body formed of at least one thermally conductive material. The body is disposed between and sealed to the lower and upper lids and defines at least one inlet manifold configured to receive a coolant, at least one manifold configured to exhaust the coolant. The inlet and outlet manifolds are interleaved and are disposed in a circular or spiral arrangement. A number of millichannels are formed in at least one of the lower and upper lids, are disposed in a radial arrangement, and are configured to receive the coolant from the inlet manifolds and to deliver the coolant to the outlet manifolds. The millichannels and inlet and outlet manifolds are further configured to cool one of the upper and lower contact surfaces of the electronic device package.

### DRAWINGS

These and other features, aspects, and advantages of the present invention will become better understood when the following detailed description is read with reference to the accompanying drawings in which like characters represent like parts throughout the drawings, wherein:
**FIG. 1** depicts an electronic device package with upper and lower heatsinks;
**FIG. 2** is a perspective view of a heat sink body with circular manifolds;
**FIG. 3** is a cross-sectional view of a single sided heat sink, with the radial millichannels formed in the upper lid;
**FIG. 4** is a cross-sectional view of a double sided heat sink, with the radial millichannels formed in the lower and upper lids;
**FIG. 5** is a top view of a heat sink body with circular manifolds and the radial millichannels formed in the body;
**FIG. 6** illustrates a heatsink design, which increases the number of radial channels;
**FIG. 7** is an inverse model of a double-sided heat sink with the radial channels formed in the lids;
**FIG. 8** is an inverse model of a double-sided heat sink with the radial channels formed in the body;
**FIG. 9** is a cross-sectional view of a single sided heat sink, with the radial millichannels formed in the body; and
**FIG. 10** is a top view of a heat sink body with spiral manifolds.

### DETAILED DESCRIPTION

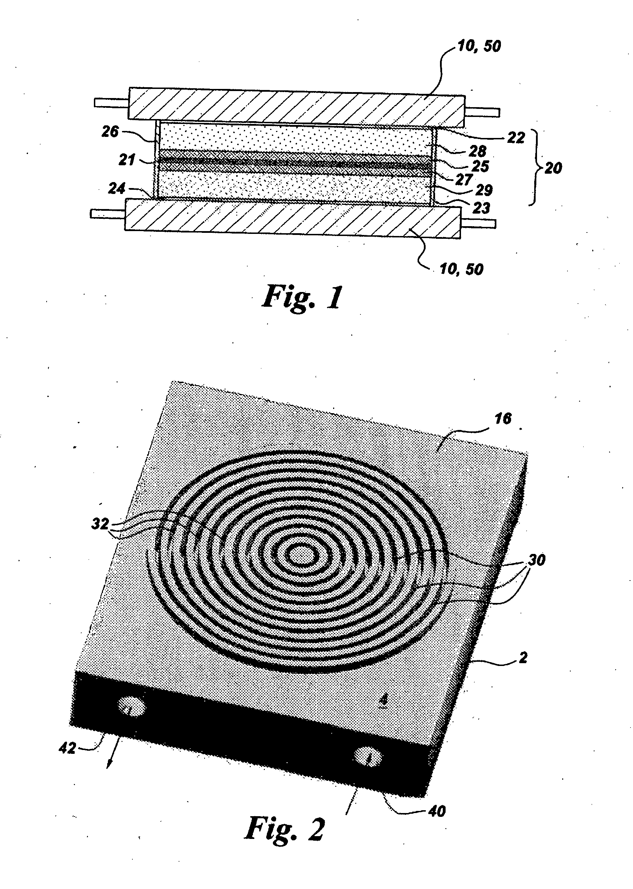

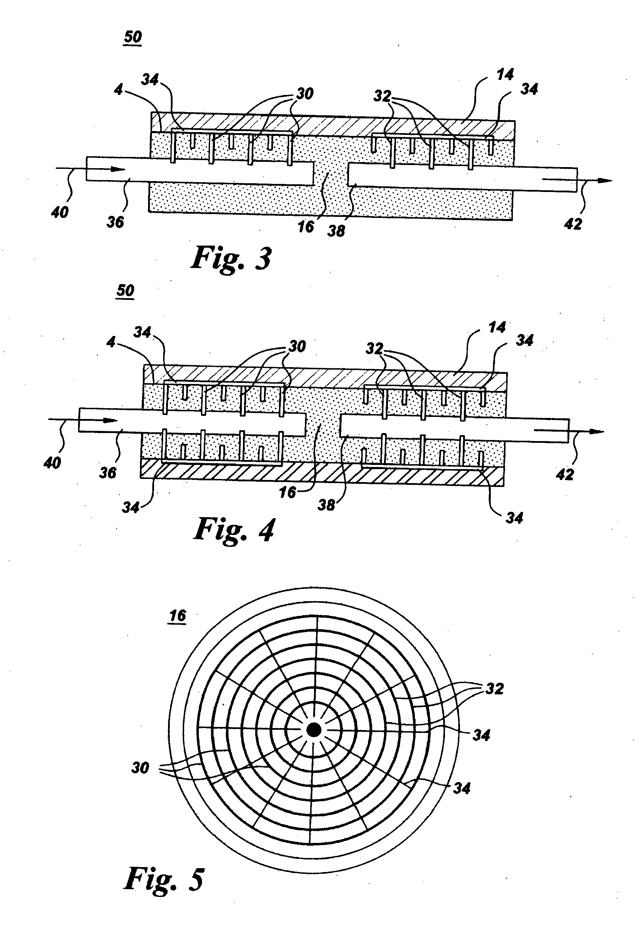

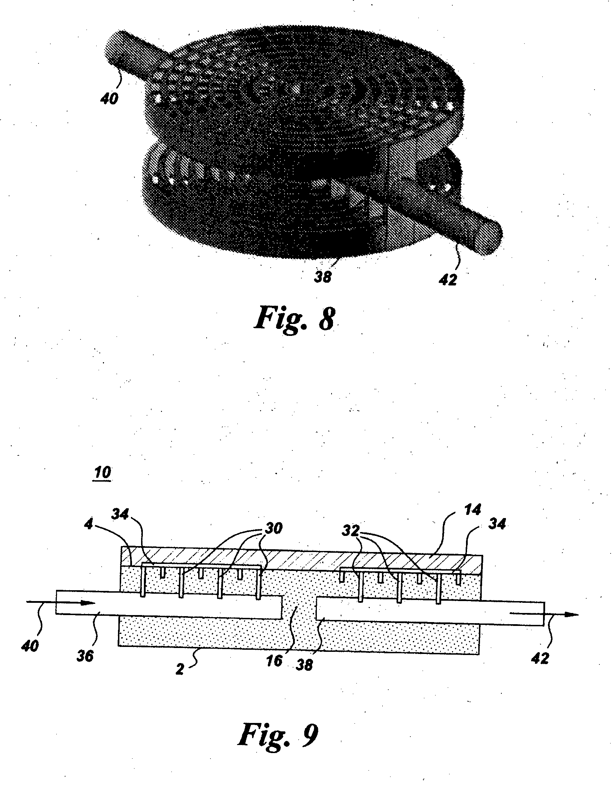

A heat sink 10 for cooling at least one electronic device package 20 is described with reference to FIGS. 1, 2, 5, 6, and 8 10. As indicated, for example in FIG. 1, an exemplary electronic device package 20 has an upper contact surface 22 and a lower contact surface 24. For this arrangement, the heat sink 10 comprises a lower lid 12 (not shown in FIG. 9 but similar to that shown in FIG. 4), an upper lid 14 (FIG. 9) and a body 16 (FIG. 9) formed of at least one thermally conductive material. The thermally conductive material is selected from the group consisting of copper, aluminum, nickel, molybdenum, titanium, copper alloys, nickel alloys, molybdenum alloys, titanium alloys, aluminum silicon carbide (AlSiC), aluminum graphite and silicon nitride ceramic. For particular configurations, the lower and upper lids 12, 14 and body 16 are formed of the same thermally conductive material(s). However, for other arrangements, different materials may be used.

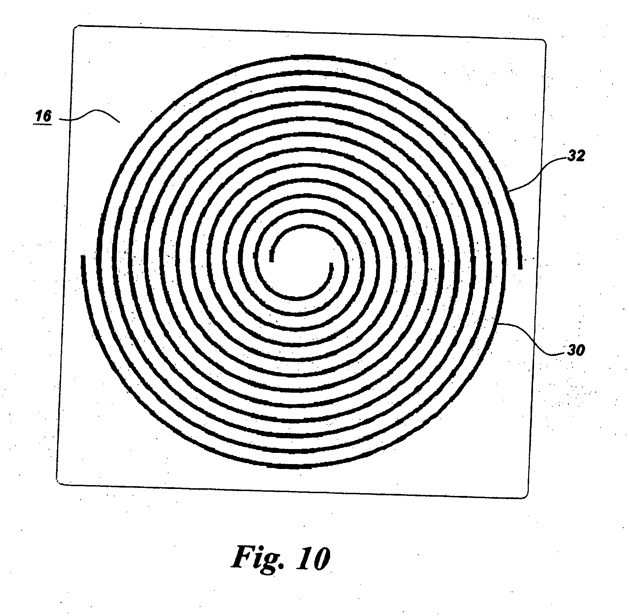

Similar to the arrangement shown in FIG. 4, the body 16 is disposed between and sealed to the lower and upper lids 12, 14. The lids 12, 14 may be welded, brazed or diffusion bonded to the body 16, and conventional welding, brazing or diffusion bonding techniques may be employed. The body 16 defines a number of inlet manifolds 30 configured to receive a coolant. Non-limiting examples of the coolant include de-ionized water and other non-electrically conductive liquids. In addition, for certain applications, the coolant may comprise an electrically conductive liquid. The body 16 further defines a number of outlet manifolds 32 configured to exhaust the coolant. As indicated, for example, in FIG. 2, the inlet and outlet manifolds 30, 32 are interleaved (interdigitated) and may be disposed in a circular arrangement (also referred to herein as axial). The body 16 and lids 12, 14 can be cast and/or machined. As shown for example, in FIG. 10, the inlet and outlet manifolds 30, 32 may be disposed in a spiral arrangement. For the example spiral arrangement shown in FIG. 10, the inlet and outlet manifolds (30, 32) are spirals, which turn the same way but are 180 degrees out of phase. Beneficially, this spiral arrangement reduces the number of machine movements needed to form the manifolds dramatically (for example from 22 for the arrangement shown in FIG. 2 to two for the arrangement of FIG. 10). For example, the pieces 12, 14 16 can be cast and then machined to further define fine features and surface requirements.

As used herein, the phrases "circular arrangement" and "axial arrangement" should be understood to encompass both curved and straight "circular" passages connecting the radial passages. For the arrangement shown in FIGS. 5 and 9, a number of millichannels 34 are formed in the body 16. In addition, although not expressly illustrated, the millichannels 34 may be formed in both the body 16 and in one or both of the lids 12, 14, in order to maximize the number of radial channels leading to a further reduction in pressure drop. As indicated in FIGS. 5 and 9, for example, the millichannels 34 are disposed in a radial arrangement and are configured to receive the coolant from the inlet manifolds 30 and to deliver the coolant to the outlet manifolds 32. The millichannels 34 and inlet and outlet manifolds 32, 34 are further configured to cool one of the upper and lower contact surfaces 22, 24 of the electronic device package 20, as schematically indicated in FIG. 1.

These internal flow structures take coolant from the inlet chamber 36 and distribute it across the entire cooled surface for uniform thermal performance. The coolant passes through the circular manifolds 30, then through the radial millichannels 34 to the other set of circular manifolds 32, and back through radial millichannels 34 to the outlet chamber 38. The manifolds and millichannels are machined or cast into the base material. For this arrangement, the flow passages (manifolds and millichannels) are hermetically sealed by the lids 12, 14. Beneficially, by using the lids and having the heat sink hermetically sealed allows for cooling channels to extend beyond the pole face of the device that is being cooled. This allows for heat spreading effects to be utilized and helps to prevent coolant leakage during disassembly and service.

For particular embodiments, the manifolds 30, 32 have relatively larger widths than the millichannels 34. In one non-limiting example, the width of the millichannels was in a range of about 0.5 mm to about 2.0 mm, and the depth of the millichannels was in a range of about 0.5 mm to about 2 mm. In particular, the cross-sectional area of the channels may be determined to ensure pressure uniformity on the semiconductor. By making the pressure distribution on the semiconductor more uniform, the performance of the semiconductor is not compromised.

Further, it should be noted that the millichannels 34 and manifolds 30, 32 could have a variety of cross-sectional shapes, including but not limited to, rounded, circular, trapezoidal, triangular, and square/rectangular cross sections. The passage shape is selected based on the application and manufacturing constraints and affects the applicable manufacturing methods, as well as coolant flow. Beneficially, the incorporation of millichannels 34 into the heat sink 10 significantly increases the surface area of heat conduction from the semiconductor device 20 to the coolant.

In addition, at least one of the inlet and outlet manifolds 30, 32 has a variable depth. For example, the depth of the inlet manifolds 30 may have a maximum value at the inlet distribution chamber 36 and a minimum value at the outlet chamber 38. Similarly, the depth of the outlet manifolds 32 may have a minimum value at the inlet distribution chamber 36 and a maximum value at the outlet chamber 38. Beneficially, this tapered arrangement achieves a more uniform flow distribution through the cooling circuit.

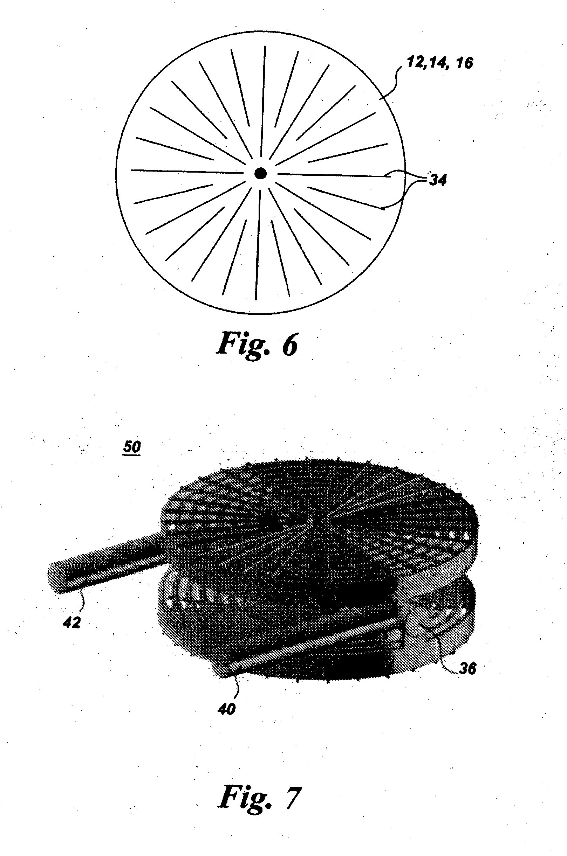

FIG. 6 illustrates a design to increase the number of radial channels to facilitate a reduction in pressure drop with a corresponding improvement in cooling efficiency. More particularly, for the example arrangement shown in FIG. 6, the number of radial millichannels 34 is larger near the circumference of the body 16 relative to the number of radial millichannels 34 near the center of the body 16. This arrangement permits the inclusion of additional radial channels for given spatial and machining constraints.

For the illustrated arrangements, the body 16 further defines an inlet distribution chamber 36 configured to supply the coolant to the inlet manifolds 30, an outlet chamber 38 configured to receive the coolant from the outlet manifolds 32, an inlet plenum 40 configured to supply the coolant to the inlet chamber 36, and an outlet plenum 42 configured to receive the coolant from the outlet chamber 38. FIG. 7 is an inverse model showing a perpendicular arrangement for the chambers 36, 38 relative to the respective plenum 40, 42. However, only the end of inlet chamber 36 is shown in FIG. 7.

For the example, configuration shown in FIG. 8, the inlet distribution chamber 36 and the inlet plenum 40 are arranged linearly, and the outlet chamber 38 and the outlet plenum 42 are arranged linearly. As used here, the term "linearly" should be understood to encompass orientations of the chambers 36, 38 relative to the respective plenum 40, 42 that are within plus or minus ten degrees (+/- 10°) of one another.) FIG. 8 is an inverse model showing a linear arrangement for the chambers 36, 38 relative to the respective plenum 40, 42. However, only the end of outlet chamber 38 is shown in FIG. 8.

For the example, configuration shown in FIG. 7, the inlet distribution chamber 36 and the inlet plenum 40 are arranged perpendicularly, and the outlet chamber 38 and the outlet plenum 42 are arranged perpendicularly. As used here, the term "perpendicularly" should be understood to encompass orientations of the chambers 36, 38 relative to the respective plenum 40, 42 that are within (90° +/- 10°) of one another. FIG. 7 is an inverse model showing a perpendicular arrangement for the chambers 36, 38 relative to the respective plenum 40, 42. Beneficially, by placing the coolant inlet plenum 40 and outlet plenum 42 in the same face, the fluid connections are simplified. For example, this configuration may require four holes to be bored for the fluid delivery and removal, two of which are later plugged.

For particular configurations, the heat sink 10 is configured for cooling a number of electronic device packages 20. FIG. 8 illustrates an example double-sided heat sink 10 configuration. For this arrangement, a first subset of the inlet and outlet manifolds 30, 32 and radial millichannels 34 are formed in a first surface 2 (indicated in FIG. 2) of the body 16, and a second subset of the inlet and outlet manifolds 30, 32 and radial millichannels 34 are formed in the second surface 4 (indicated in FIG. 2) of the body. In addition, although not expressly illustrated, the millichannels 34 may be formed in both the body 16 and in the lids 12, 14, in order to maximize the number of radial channels leading to a further reduction in pressure drop. Similar to the arrangement in FIG. 4, the first subset of the inlet and outlet manifolds 30, 32 and radial millichannels 34 is configured to cool an upper contact surface 22 (see FIG. 1) of one of the electronic device packages 20 via the lower lid 12 with the coolant, and the second subset of inlet and outlet manifolds 30, 32 and radial millichannels 34 is configured to cool a lower contact surface 24 (see FIG. 1) of another of the electronic device packages 20 via the upper lid 14 with the coolant, as schematically depicted in FIG. 1. A double-sided heat sink 50 is shown in FIG. 4. However, for the arrangement shown in FIG. 4, the radial millichannels 34 are formed in the lids 12, 14, whereas for the present configuration, the radial millichannels 34 are formed in the body 16 (and optionally also in the lids).

It should be noted that the specific arrangement shown in FIG. 1 is merely illustrative, and any number of electronic device packages 20 and corresponding heat sinks 10, 50 for cooling the electronic device packages may be incorporated into a given stack, depending on the specific application. One of the many benefits of the present invention is its flexibility and modularity for cooling a desired number of device packages.

In addition, the heat sinks 10, 50 can be single-sided or double-sided. One-sided heat sink configurations 10, 50 for cooling an electronic device package 20 are described with reference to FIGS. 3 and 9. The heat sink 10, 50 comprises a lid 12, 14 formed of at least one thermally conductive material and a body 16 formed of at least one thermally conductive material. The body 16 is sealed to the lid 12, 14, and the construction of the lid and body is described above. The body 16 defines a number of inlet manifolds 30 configured to receive a coolant and a number of outlet manifolds 32 configured to exhaust the coolant. The inlet and outlet manifolds 30, 32 are interleaved (interdigitated) and are disposed in a circular arrangement. A number of millichannels 34 are formed in the body 16 (as shown, for example, in FIGS. 5 and 9) and/or the lid 12, 14 (as shown, for example, in FIG. 3). As noted above, for certain arrangements, the millichannels 34 may be formed in both the body 16 and in the lids 12, 14, in order to maximize the number of radial channels. The millichannels 34 are disposed in a radial arrangement and are configured to receive the coolant from the inlet manifolds 30 and to deliver the coolant to the outlet manifolds 32. The millichannels 34 and inlet and outlet manifolds 32, 34 are further configured to cool one of the upper or lower contact surfaces 22, 24 of the electronic device package 20, as schematically depicted in FIG. 1.

For the example configuration shown in FIGS. 5 and 9, the millichannels 34 are formed in the body 16. More particularly, the inlet and outlet manifolds 30, 32 and radial millichannels 34 are formed in only one of the first surface 2 or second surface 4 of the body 16 (on the second surface 4 for the case of FIG. 9), such that the heat sink 10 is a single sided heat sink 10, as shown for example in FIG. 9.

For the example configuration shown in FIG. 3, the millichannels 34 are formed in the lid 14. More particularly, the inlet and outlet manifolds 30, 32 are formed in only one of the first surface 2 or second surface 4 of the body 16 (on the second surface 4 for the case of FIG. 3), which surface 4 is adjacent the lid 14, such that the heat sink 50 is a single sided heat sink 50, as shown for example in FIG. 3.

For the exemplary embodiments described above with reference to FIGS. 1-9, the upper contact surface 22 and lower contact surface 24 can be circular in cross-section, and the body 16 can be cylindrical (i.e., a disk or hockey-puck arrangement). However, other geometries can be employed, including without limitation, square and rectangular cross-sections. For the example arrangement depicted in FIG. 1, the electronic device package 20 is a press-package 20. Although the invention is not limited to any specific device structure, the following example press-package configuration is provided for illustrative purposes. In the example, the press-package 20 comprises at least one semiconductor device 21 formed on a wafer 23, upper and lower coefficient of thermal-expansion (CTE) matched plates 25, 27, and upper and lower electrodes 28, 29. The wafer 23 is disposed between the CTE plates 25, 27, the upper electrode 28 is disposed above the upper CTE plate 25, and the lower CTE plate 27 is disposed above the lower electrode 29, as shown for example in FIG. 1. For the press-package embodiment, each of the wafer 23, CTE plates 25, 27 and electrodes 28, 29 may have a circular cross-section. Non-limiting examples of semiconductor devices include IGCTs, GTOs and IGBTs. The present invention finds application to semiconductor devices manufactured from a variety of semiconductors, non-limiting examples of which include silicon (Si), silicon carbide (SiC), gallium nitride (GaN), and gallium arsenide (GaAs). The press-package typically includes an insulating (for example, ceramic) housing 26, as indicated for example in FIG. 1. Although FIG. 1 shows the heat sinks 10, 50 as extending outside the housing 26, in other embodiments, the bodies 16 of the heat sinks 10, 50 are disposed within the housing 26. Moreover, electrodes 28, 29 can extend vertically beyond the bounds of housing 26, for example with a compliant seal disposed between the outer circumference of electrodes 28 (and 29) and the housing 26. In addition, the heat sinks 10, 50 can extend out of the housing (as shown) to enable electrical connections and for placing other devices that need to be cooled. Therefore, the body 16 can have a larger diameter than housing 26.

Another heat sink configuration is described with reference to FIGS. 1, 2, 4, 6 and 7. As shown for example, in FIG. 1, a heat sink 50 is provided, for cooling at least one electronic device package 20. As indicated in FIG. 1, the electronic device package has upper and lower contact surfaces 22, 24. As indicated, for example, in FIG. 4, the heat sink 50 comprises lower and upper lids 12, 14 and a body 16 formed of at least one thermally conductive material. Example materials for the body and lids are discussed above. As noted above, the body and lids may be formed from the same or different materials. As indicated in FIGS. 4 and 7, for example, the body 16 is disposed between and sealed to the lower and upper lids 12, 14, for example by welding, brazing or diffusion bonding. Thus, the flow passages (manifolds and millichannels) are hermetically sealed by the lids 12, 14, facilitating the use of heat spreading effects and preventing coolant leakage during disassembly and service.

As indicated, for example, in FIG. 2, the body 16 defines a number of inlet manifolds 30 configured to receive a coolant and a number of outlet manifolds 32 configured to exhaust the coolant. The inlet and outlet manifolds 30, 32 are interleaved (interdigitated) and are disposed in a circular arrangement. As shown, for example, in FIGS. 4 and 7, millichannels 34 are formed in at least one of the lower and upper lids 12, 14. For the particular arrangement shown in FIGS. 4 and 7, the millichannels 34 are formed in each of the lower and upper lids 12, 14. The millichannels 34 are disposed in a radial arrangement and are configured to receive the coolant from the inlet manifolds 30 and to deliver the coolant to the outlet manifolds 32. The millichannels 34 and inlet and outlet manifolds 32, 34 are further configured to cool one of the upper and lower contact surfaces 22, 24 of the electronic device package 20, as indicated schematically in FIG. 1. Beneficially, placing radial channels in the lids reduces the thermal resistance by placing the coolant closer to the electronic device package 20.

Example dimensions and cross-sections for the manifolds and millichannels are presented above. In addition, and as discussed above, at least one of the inlet and outlet manifolds 30, 32 may have a variable depth. Beneficially, such a tapered arrangement achieves a more uniform flow distribution through the cooling circuit.

For the example configuration shown in FIG. 6, the number of radial millichannels 34 is larger near the circumference of the lids 12, 14 relative to the number of radial millichannels 34 near the center of the lids 12, 14. As noted above, the arrangement shown in FIG. 6 provides enhanced cooling by permitting the inclusion of additional radial channels for given spatial and machining constraints.

As shown for example in FIGS. 4 and 7, the body 16 further defines an inlet distribution chamber 36 configured to supply the coolant to the inlet manifolds 30, an outlet chamber 38 configured to receive the coolant from the outlet manifolds 32, an inlet plenum 40 configured to supply the coolant to the inlet chamber 36, and an outlet plenum 42 configured to receive the coolant from the outlet chamber 38. As noted above, FIG. 7 is an inverse model showing a perpendicular arrangement for the chambers 36, 38 relative to the respective plenum 40, 42. However, only the end of inlet chamber 36 is shown in FIG. 7. The inlet distribution chamber 36 and the inlet plenum 40 may be arranged linearly, and the outlet chamber 38 and the outlet plenum 42 may be arranged linearly, similar to the configuration shown in FIG. 8. For other configurations, the inlet distribution chamber 36 and the inlet plenum 40 may be arranged perpendicularly, and the outlet chamber 38 and the outlet plenum 42 may be arranged perpendicularly, as shown in FIG. 7.

For particular configurations, the heat sink 50 is configured for cooling a number of electronic device packages 20. FIGS. 4 and 7 illustrates an example double-sided heat sink 50 configuration. For this arrangement, a first subset of the inlet manifolds and outlet manifolds 30, 32 are formed in the first surface 2 of the body 16, and a first subset of the millichannels 34 are formed in the lower lid 12, as indicated for example in FIG. 4. A second subset of the inlet manifolds and outlet manifolds 30, 32 are formed in the second surface 4 of the body 16, and a second subset of the millichannels 34 are formed in the upper lid 14, as also indicated in FIG. 4. The first subsets of the inlet and outlet manifolds 30, 32 and the millichannels 34 are configured to cool an upper contact surface 22 of one of the electronic device packages 20 with the coolant, and the second subsets of inlet and outlet manifolds 30, 32 and the millichannels 34 are configured to cool a lower contact surface 24 of another of the electronic device packages 20 with the coolant, as schematically depicted in FIG. 1.

By providing higher reliability and a larger operating margin due to improved thermal performance, the heat sinks 10, 50 are particularly desirable for applications demanding very high reliability, such as oil and gas liquefied natural gas (LNG) and pipeline drives, oil and gas sub-sea transmission and distribution, and drives. In addition, the heat sinks 10, 50 can be employed in a variety of applications, non-limiting examples of which include high power applications, such as metal rolling mills, paper mills and traction.

Beneficially, by forming a hermetic seal, the heat sinks 10, 50 prevent the coolant from leaking onto the electronics during assembly, disassembly, or servicing. In addition, the heat sinks 10, 50 provide high-performance cooling, in a uniform manner across the pole face of the electronic device package 20.

Although only certain features of the invention have been illustrated and described herein, many modifications and changes will occur to those skilled in the art. It is, therefore, to be understood that the appended claims are intended to cover all such modifications and changes as fall within the scope of the invention.

## Claims

1. A heat sink (10, 50) for cooling an electronic device package (20), the electronic device package having an upper contact surface (22) and a lower contact surface (24), the heat sink comprising:
a lid (12, 14) formed of at least one thermally conductive material; and
a body (16) formed of at least one thermally conductive material, wherein the body (16) is sealed to the lid (12, 14), and wherein the body (16) defines:
at least one inlet manifold (30) configured to receive a coolant;
at least one manifold (32) configured to exhaust the coolant, wherein the inlet and outlet manifolds (30, 32) are interleaved and are disposed in a circular or spiral arrangement;
wherein a plurality of millichannels (34) are formed in either or both of the body (16) and the lid (12, 14), wherein the millichannels (34) are disposed in a radial arrangement and are configured to receive the coolant from the inlet manifolds (30) and to deliver the coolant to the outlet manifolds (32), and
wherein the millichannels (34) and inlet and outlet manifolds (32, 34) are further configured to cool one of the upper and lower contact surfaces (22, 24) of the electronic device package (20);
**characterized in that** at least one of the inlet and outlet manifolds is a tapered manifold and has a variable depth.

2. The heat sink (10) of Claim 1, wherein the millichannels (34) are formed in the body (16), wherein the body (16) has a first surface (2) and a second surface (4), and wherein the inlet and outlet manifolds (30, 32) and radial millichannels (34) are formed in only one of the first surface (2) or second surface (4) of the body (16), which surface (2, 4) is adjacent the lid.(12, 14), such that the heat sink (10) is a single-sided heat sink (10).

3. The heat sink (10) of Claim 2, wherein the millichannels (34) are also formed in the lid (12,14).

4. The heat sink (50) of any preceding Claim, wherein the millichannels (34) are formed in the lid (12, 14), wherein the body (16) has a first surface (2) and a second surface (4), and wherein the inlet and outlet manifolds (30, 32) are formed in only one of the first surface (2) or second surface (4) of the body (16), which surface (2, 4) is adjacent the lid (12, 14), such that the heat sink (50) is a single-sided heat sink (50), and wherein the inlet and outlet manifolds (30, 32) are disposed in a circular or spiral arrangement.

5. The heat sink (10) of claim 1, the heat sink comprising:
a lower lid (12) formed of at least one thermally conductive material; and
an upper lid (14) formed of at least one thermally conductive material;
wherein the body (16) is disposed between and sealed to the lower and upper lids (12, 14), wherein the plurality of millichannels (34) are formed in the body (16).

6. The heat sink (10) of any preceding Claim, wherein the thermally conductive material is selected from the group consisting of copper, aluminum, nickel, molybdenum, titanium, copper alloys, nickel alloys, molybdenum alloys, titanium alloys, aluminum silicon carbide (AlSiC), aluminum graphite and silicon nitride ceramic, wherein a cross-section of the millichannels (34) and a cross-section of the manifolds (30, 32) are selected from the group consisting of rounded, circular, trapezoidal, triangular, and rectangular cross sections.

7. The heat sink (10) of Claim 5 or Claim 6 when dependent on claim 5, wherein the millichannels (34) are also formed in at least one of the lower and upper lids (12,14).

8. The heat sink (50) of claim 1, the heat sink comprising:
a lower lid (12) formed of at least one thermally conductive material; and
an upper lid (14) formed of at least one thermally conductive material;
wherein the body (16) is disposed between and sealed to the lower and upper lids (12, 14), wherein the plurality of millichannels (34) are formed in at least one of the lower and upper lids (12, 14).

9. The heat sink (50) of Claim 8, wherein the at least one thermally conductive material is selected from the group consisting of copper, aluminum, nickel, molybdenum, titanium, copper alloys, nickel alloys, molybdenum alloys, titanium alloys, aluminum silicon carbide (AlSiC), aluminum graphite and silicon nitride ceramic, wherein a cross-section of the millichannels (34) and a cross-section of the manifolds (30, 32) are selected from the group consisting of rounded, circular, trapezoidal, triangular, and rectangular cross sections.

## Patentansprüche

1. Kühlkörper (10, 50) zum Kühlen von einem elektronischen Gerätepaket (20), wobei das elektronische Gerätepaket eine obere Kontaktfläche (22) und eine untere Kontaktfläche (24) hat, wobei der Kühlkörper Folgendes aufweist:
einen Deckel (12, 14), geformt aus mindestens einem thermisch leitfähigen Material; und
einen Körper (16), geformt aus mindestens einem thermisch leitfähigen Material, wobei der Körper (16) abdichtend mit dem Deckel (12, 14) verbunden ist und wobei der Körper (16) Folgendes definiert:
mindestens einen Einlassverteiler (30), konfiguriert, um ein Kühlmittel aufzunehmen;
mindestens einen Verteiler (32), konfiguriert, um das Kühlmittel auszulassen, wobei die Einlass- und Auslassverteiler (30, 32) verschränkt und kreisförmig oder spiralförmig angeordnet sind;
wobei eine Vielzahl von Millikanälen (34) im Körper (16) und/oder Deckel (12, 14) ausgebildet ist, wobei die Millikanäle (34) radial angeordnet und konfiguriert sind, um das Kühlmittel von den Einlassverteilern (30) aufzunehmen und das Kühlmittel an die Auslassverteiler (32) abzugeben, und
wobei die Millikanäle (34) und die Einlass- und Auslassverteiler (32, 34) weiter konfiguriert sind, um die obere oder untere Kontaktfläche (22, 24) des elektronischen Gerätepakets (20) zu kühlen;
**dadurch gekennzeichnet, dass** der Einlass- und/oder Auslassverteiler ein konischer Verteiler mit variabler Tiefe ist.

2. Kühlkörper (10) nach Anspruch 1, wobei die Millikanäle (34) im Körper (16) ausgebildet sind, wobei der Körper (16) eine erste Oberfläche (2) und eine zweite Oberfläche (4) hat und wobei die Einlass- und Auslassverteiler (30, 32) und radialen Millikanäle (34) nur in entweder der ersten Oberfläche (2) oder der zweiten Oberfläche (4) des Körpers (16) ausgebildet sind, wobei die Oberfläche (2, 4) an den Deckel (12, 14) angrenzt, sodass der Kühlkörper (10) ein einseitiger Kühlkörper (10) ist.

3. Kühlkörper (10) nach Anspruch 2, wobei die Millikanäle (34) ebenfalls im Deckel (12, 14) ausgebildet sind.

4. Kühlkörper (50) nach einem der vorstehenden Ansprüche, wobei die Millikanäle (34) im Deckel (12, 14) ausgebildet sind, wobei der Körper (16) eine erste Oberfläche (2) und eine zweite Oberfläche (4) hat und wobei die Einlass- und Auslassverteiler (30, 32) nur in entweder der ersten Oberfläche (2) oder der zweiten Oberfläche (4) des Körpers (16) ausgebildet sind, wobei die Oberfläche (2, 4) an den Deckel (12, 14) angrenzt, sodass der Kühlkörper (50) ein einseitiger Kühlkörper (50) ist, und wobei die Einlass- und Auslassverteiler (30, 32) kreisförmig oder spiralförmig angeordnet sind.

5. Kühlkörper (10) nach Anspruch 1, wobei der Kühlkörper Folgendes aufweist:
einen unteren Deckel (12), geformt aus mindestens einem thermisch leitfähigen Material; und
einen oberen Deckel (14), gebildet aus mindestens einem thermisch leitfähigen Material;
wobei der Körper (16) zwischen dem unteren und dem oberen Deckel (12, 14) angeordnet und abdichtend damit verbunden ist, wobei die Vielzahl von Millikanälen (34) im Körper (16) ausgebildet ist.

6. Kühlkörper (10) nach einem der vorstehenden Ansprüche, wobei das thermisch leitfähige Material ausgewählt ist aus der Gruppe bestehend aus Kupfer, Aluminium, Nickel, Molybdän, Titan, Kupferlegierungen, Nickellegierungen, Molybdänlegierungen, Titanlegierungen, Aluminiumsiliziumcarbid (AlSiC), Aluminium-Graphit und Siliziumnitrid-Keramik, wobei ein Querschnitt der Millikanäle (34) und ein Querschnitt der Verteiler (30, 32) ausgewählt sind aus der Gruppe bestehend aus abgerundeten, kreisförmigen, trapezförmigen, dreieckigen und rechteckigen Querschnitten.

7. Kühlkörper (10) nach Anspruch 5 oder 6, sofern von Anspruch 5 abhängig, wobei die Millikanäle (34) ebenfalls in dem oberen und/oder dem unteren Deckel (12, 14) ausgebildet sind.

8. Kühlkörper (50) nach Anspruch 1, wobei der Kühlkörper Folgendes aufweist:
einen unteren Deckel (12), geformt aus mindestens einem thermisch leitfähigen Material; und
einen oberen Deckel (14), geformt aus mindestens einem thermisch leitfähigen Material;
wobei der Körper (16) zwischen dem unteren und dem oberen Deckel (12, 14) angeordnet und abdichtend damit verbunden ist, wobei die Vielzahl der Millikanäle (34) in dem unteren und/oder dem oberen Deckel (12, 14) ausgebildet ist.

9. Kühlkörper (50) nach Anspruch 8, wobei das mindestens eine thermisch leitfähige Material ausgewählt ist aus der Gruppe bestehend aus Kupfer, Aluminium, Nickel, Molybdän, Titan, Kupferlegierungen, Nickellegierungen, Molybdänlegierungen, Titanlegierungen, Aluminiumsiliziumcarbid (AlSiC), Aluminium-Graphit und Siliziumnitrid-Keramik, wobei ein Querschnitt der Millikanäle (34) und ein Querschnitt der Verteiler (30, 32) ausgewählt sind aus der Gruppe bestehend aus abgerundeten, kreisförmigen, trapezförmigen, dreieckigen und rechteckigen Querschnitten.

## Revendications

1. Puits de chaleur (10, 50) pour refroidir un paquet de dispositifs électroniques (20), le paquet de dispositifs électroniques ayant une surface de contact supérieure (22) et une surface de contact inférieure (24), le puits de chaleur comprenant :
un couvercle (12, 14) formé d'au moins un matériau thermoconducteur ; et
un corps (16) formé d'au moins un matériau thermoconducteur, dans lequel le corps (16) est scellé sur le couvercle (12, 14) et dans lequel le corps (16) définit :
au moins un collecteur d'entrée (30) configuré pour recevoir un réfrigérant ;
au moins un collecteur (32) configuré pour évacuer le réfrigérant, dans lequel les collecteurs d'entrée et de sortie (30, 32) sont intercalés et sont disposés dans un aménagement circulaire ou spiralé ;
dans lequel une pluralité de millicanaux (34) sont formés dans l'un et/ou l'autre du corps (16) et du couvercle (12, 14), dans lequel les millicanaux (34) sont disposés dans un aménagement radial et sont configurés pour recevoir le réfrigérant des collecteurs d'entrée (30) et pour délivrer le réfrigérant aux collecteurs de sortie (32) et
dans lequel les millicanaux (34) et les collecteurs d'entrée et de sortie (32, 34) sont encore configurés pour refroidir l'une des surfaces de contact supérieure et inférieure (22, 24) du paquet de dispositifs électroniques (20) ;
**caractérisé en ce qu'**au moins l'un des collecteurs d'entrée et de sortie est un collecteur aminci et a une profondeur variable.

2. Puits de chaleur (10) selon la revendication 1, dans lequel les millicanaux (34) sont formés dans le corps (16), dans lequel le corps (16) a une première surface (2) et une seconde surface (4) et dans lequel les collecteurs d'entrée et de sortie (30, 32) et les millicanaux radiaux (34) sont formés dans seulement l'une de la première surface (2) ou de la seconde surface (4) du corps (16), laquelle surface (2, 4) est adjacente au couvercle (12, 14) de sorte que le puits de chaleur (10) soit un puits de chaleur à face unique (10).

3. Puits de chaleur (10) selon la revendication 2, dans lequel les millicanaux (34) sont également formés dans le couvercle (12, 14).

4. Puits de chaleur (50) selon l'une quelconque des revendications précédentes, dans lequel les millicanaux (34) sont formés dans le couvercle (12, 14), dans lequel le corps (16) a une première surface (2) et une seconde surface (4) et dans lequel les collecteurs d'entrée et de sortie (30, 32) sont formés dans seulement l'une de la première surface (2) ou de la seconde surface (4) du corps (16), laquelle surface (2, 4) est adjacente au couvercle (12, 14) de sorte que le puits de chaleur (50) soit un puits de chaleur à face unique (50), et dans lequel les collecteurs d'entrée et de sortie (30, 32) sont disposés dans un aménagement circulaire ou spiralé.

5. Puits de chaleur (10) selon la revendication 1, le puits de chaleur comprenant :
un couvercle inférieur (12) formé d'au moins un matériau thermoconducteur ; et
un couvercle supérieur (14) formé d'au moins un matériau thermoconducteur ;
dans lequel le corps (16) est disposé entre les couvercles supérieur et inférieur (12, 14) et scellé à ceux-ci, la pluralité de millicanaux (34) étant formés dans le corps (16).

6. Puits de chaleur (10) selon l'une quelconque des revendications précédentes, dans lequel le matériau thermoconducteur est choisi dans le groupe constitué du cuivre, de l'aluminium, du nickel, du molybdène, du titane, d'alliages de cuivre, d'alliages de nickel, d'alliages de molybdène, d'alliages de titane, de carbure d'aluminium et de silicium (AlSiC), d'aluminium-graphite et de céramique de nitrure de silicium, dans lequel une section transversale des millicanaux (34) et une section transversale des collecteurs (30, 32) sont choisies dans le groupe constitué de sections transversales arrondies, circulaires, trapézoïdales, triangulaires et rectangulaires.

7. Puits de chaleur (10) selon la revendication 5 ou la revendication 6 dans la mesure où elle dépend de la revendication 5, dans lequel les millicanaux (34) sont également formés dans au moins l'un des couvercles inférieur et supérieur (12, 14).

8. Puits de chaleur (50) selon la revendication 1, le puits de chaleur comprenant :
un couvercle inférieur (12) formé d'au moins un matériau thermoconducteur ; et
un couvercle supérieur (14) formé d'au moins un matériau thermoconducteur ;
dans lequel le corps (16) est disposé entre les couvercles inférieur et supérieur (12, 14) et scellé à ceux-ci, dans lequel la pluralité de millicanaux (34) sont formés dans au moins l'un des couvercles inférieur et supérieur (12, 14).

9. Puits de chaleur (50) selon la revendication 8, dans lequel le au moins un matériau thermoconducteur est choisi dans le groupe constitué du cuivre, de l'aluminium, du nickel, du molybdène, du titane, d'alliages de cuivre, d'alliages de nickel, d'alliages de molybdène, d'alliages de titane, de carbure d'aluminium-silicium (AlSiC), d'aluminium-graphite et de céramique de nitrure de silicium, dans lequel une section transversale des millicanaux (34) et une section transversale des collecteurs (30, 32) sont choisies dans le groupe constitué des sections transversales arrondies, circulaires, trapézoïdales, triangulaires et rectangulaires.
